(19) Europäisches Patentamt / European Patent Office / Office européen des brevets

(11) **EP 3 660 849 B1**

(12) **FASCICULE DE BREVET EUROPEEN**

(45) Date de publication et mention
de la délivrance du brevet:
**22.06.2022 Bulletin 2022/25**

(21) Numéro de dépôt: **19209000.9**

(22) Date de dépôt: **13.11.2019**

(51) Classification Internationale des Brevets (IPC):
***G11C 7/10*** *(2006.01)* ***G11C 11/417*** *(2006.01)*

(52) Classification Coopérative des Brevets (CPC):
**G11C 7/1006; G11C 7/1012; G11C 11/417;**
G11C 8/16; G11C 11/412

(54) **CIRCUIT MÉMOIRE ADAPTÉ À METTRE EN OEUVRE DES OPÉRATIONS DE CALCUL**

ADAPTIERTER SPEICHERSCHALTKREIS ZUR DURCHFÜHRUNG VON RECHENOPERATIONEN

MEMORY CIRCUIT SUITABLE FOR PERFORMING COMPUTING OPERATIONS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.11.2018 FR 1871578**

(43) Date de publication de la demande:
**03.06.2020 Bulletin 2020/23**

(73) Titulaire: **Commissariat à l'Energie Atomique et
aux Energies
Alternatives
75015 Paris (FR)**

(72) Inventeurs:
• **CHARLES, Henri-Pierre**
**38054 GRENOBLE CEDEX 9 (FR)**
• **KOOLI, Maha**
**38054 GRENOBLE CEDEX 9 (FR)**
• **NOEL, Jean-Philippe**
**38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
**EP-A1- 3 252 774**     **US-A- 5 325 500**
**US-A1- 2012 294 094**     **US-A1- 2016 189 769**
**US-A1- 2019 088 307**     **US-B1- 9 761 300**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Domaine technique

La présente description concerne le domaine des circuits mémoire. Elle vise plus particulièrement un circuit mémoire adapté à mettre en oeuvre des opérations de calcul.

Technique antérieure

Il a déjà été proposé, dans la demande de brevet européen EP3252774 (DD16812/B14843), dans la demande de brevet français N°17/62534 (DD17938/B16054) déposée le 19 décembre 2017, dans la demande de brevet français N°17/62470 (DD17955/B16064) déposée le 19 décembre 2017, dans la demande de brevet français N°17/63221 (DD17956/B16065) déposée le 26 décembre 2017, et dans la demande de brevet français N°17/62468 (DD17885/B16288) déposée le 19 décembre 2017, un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans la mémoire. Ce circuit comprend, comme dans un circuit mémoire classique, une pluralité de cellules élémentaires agencées en matrice selon des rangées et des colonnes, et un circuit de contrôle adapté à mettre en oeuvre des opérations de lecture ou d'écriture de données dans des rangées de la matrice. A la différence d'un circuit mémoire classique dans lequel une seule rangée de la matrice peut être sélectionnée à la fois lors d'une opération de lecture, le circuit de contrôle est adapté à sélectionner simultanément en lecture une pluralité de rangées de la matrice de façon à réaliser une opération ayant pour opérandes des données contenues dans les rangées sélectionnées.

Il serait souhaitable d'améliorer au moins en partie certains aspects d'un tel circuit mémoire.

Résumé de l'invention

Ainsi, un mode de réalisation prévoit un circuit mémoire comportant :

- une pluralité de cellules élémentaires de stockage agencées en matrice selon des rangées et des colonnes, les cellules d'une même colonne partageant une même ligne de bit de lecture et une même ligne de bit d'écriture ;
- un circuit interne de contrôle adapté à mettre en oeuvre une opération de calcul comprenant l'activation simultanée en lecture d'au moins deux rangées de la matrice ; et
- un circuit de permutation comportant un registre d'entrée de données, un registre de configuration, et un port de sortie, le circuit de permutation étant adapté à fournir sur son port de sortie les données mémorisées dans son registre d'entrée permutées selon une permutation définie en fonction de l'état de son registre de configuration, dans lequel le circuit de permutation est un circuit de routage configurable à architecture parallèle, tel que le temps de mise en oeuvre d'une opération de permutation soit sensiblement fixe quels que soient les contenus respectifs du registre d'entrée et du registre de configuration du circuit de permutation.

Le circuit de contrôle est en outre adapté à mettre en oeuvre une opération de permutation comprenant une étape de lecture de données de configuration stockées à l'intérieur du circuit mémoire et de copie de ces données dans le registre de configuration du circuit de permutation.

Selon un mode de réalisation, le circuit de contrôle interne est adapté à mettre en oeuvre une opération de permutation comprenant :

- l'activation en lecture d'au moins une première rangée de la matrice ;
- la copie de données lues sur les lignes de bit de lecture de la matrice dans le registre d'entrée de données du circuit de permutation ;
- la copie de données fournies sur le port de sortie du circuit de permutation sur les lignes de bit d'écriture de la matrice ; et
- l'activation en écriture d'au moins une rangée de la matrice.

Selon un mode de réalisation, l'opération de permutation comprend en outre :

- l'activation en lecture d'au moins une deuxième rangée de la matrice ; et
- la copie de données lues sur les lignes de bit de lecture de la matrice dans le registre de configuration du circuit de permutation.

Selon un mode de réalisation, le circuit mémoire comprend, en plus de la matrice de cellules élémentaires de stockage, une mémoire additionnelle destinée à stocker des données de configuration du circuit de permutation.

Selon un mode de réalisation, l'opération de permutation comprend en outre la copie de données lues dans la mémoire additionnelle dans le registre de configuration du circuit de permutation.

Selon un mode de réalisation, la mémoire additionnelle est une mémoire non volatile.

Selon un mode de réalisation, le circuit de permutation comprend une pluralité de cellules élémentaires de permutation comprenant chacune deux entrées de données e1 et e2, deux sorties de données s1 et s2, et une entrée de configuration c.

Selon un mode de réalisation, le circuit de permutation comprend*(2*log2(K)-1) cellules élémentaires de permutation agencées selon un réseau de Benes, où K est un entier désignant la dimension du registre d'entrée et du port de sortie du circuit de permutation.

Selon un mode de réalisation, le circuit de permutation comprend 16 cellules élémentaires de permutation agencées selon 5 rangées, les rangées de rang l=1 à l=3 comportant chacune 4 cellules élémentaires, et les rangées de rang l=4 à l=5 comportant chacune 2 cellules élémentaires, le registre d'entrée et le port de sortie du circuit de permutation étant de dimension 8, et l étant un entier allant de 1 à 5.

Selon un mode de réalisation, le circuit mémoire comporte en outre un circuit d'entrée-sortie configurable pour relier les lignes de bit de lecture de la matrice au registre d'entrée du circuit de permutation et/ou pour relier les lignes de bit d'écriture de la matrice au port de sortie du circuit de permutation.

Selon un mode de réalisation, le circuit mémoire comporte en outre un circuit de calcul adapté à mettre en oeuvre des opérations logiques ou arithmétiques ayant pour opérandes des données mémorisées dans la matrice de cellules élémentaires de stockage du circuit mémoire.

Selon un mode de réalisation, le circuit d'entrée-sortie est en outre configurable pour relier les lignes de bit de lecture de la matrice à un registre d'entrée du circuit de calcul et/ou pour relier les lignes de bit d'écriture de la matrice à un port de sortie du circuit de calcul.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente de façon schématique un exemple d'un circuit mémoire adapté à mettre en oeuvre des opérations de calcul ;

la figure 2 est un schéma électrique plus détaillé d'un exemple d'une cellule élémentaire de stockage d'un circuit mémoire ;

la figure 3 représente de façon schématique un exemple d'un circuit mémoire selon un mode de réalisation ;

la figure 4 représente plus en détail un exemple de réalisation d'un circuit de permutation du circuit mémoire de la figure 3 ;

la figure 5 représente un exemple de réalisation d'une cellule élémentaire de permutation du circuit de permutation de la figure 4 ;

la figure 6 représente un autre exemple de réalisation d'un circuit de permutation du circuit mémoire de la figure 3 ;

la figure 7 représente de façon schématique un autre exemple de réalisation d'un circuit mémoire selon un mode de réalisation ;

la figure 8 représente plus en détail un exemple de réalisation du circuit mémoire de la figure 7 ;

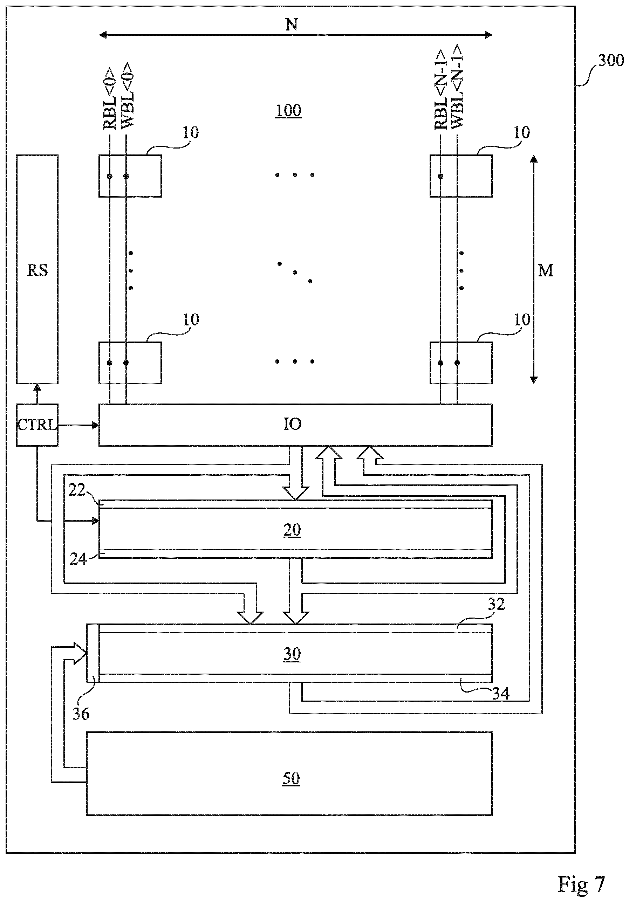

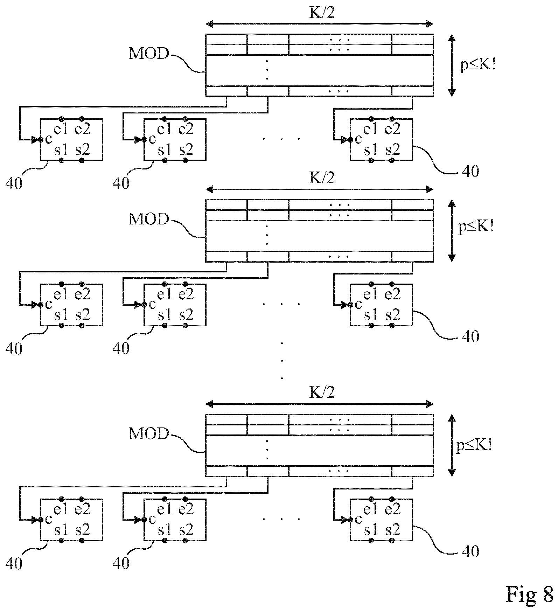

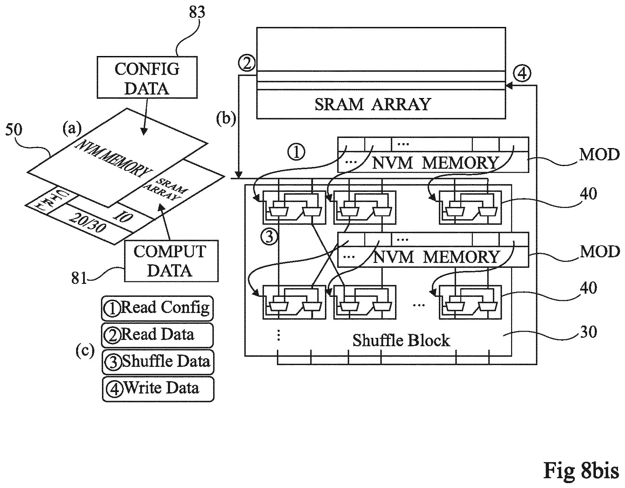

la figure 8bis est une autre illustration d'un exemple de réalisation du circuit mémoire de la figure 7 ;

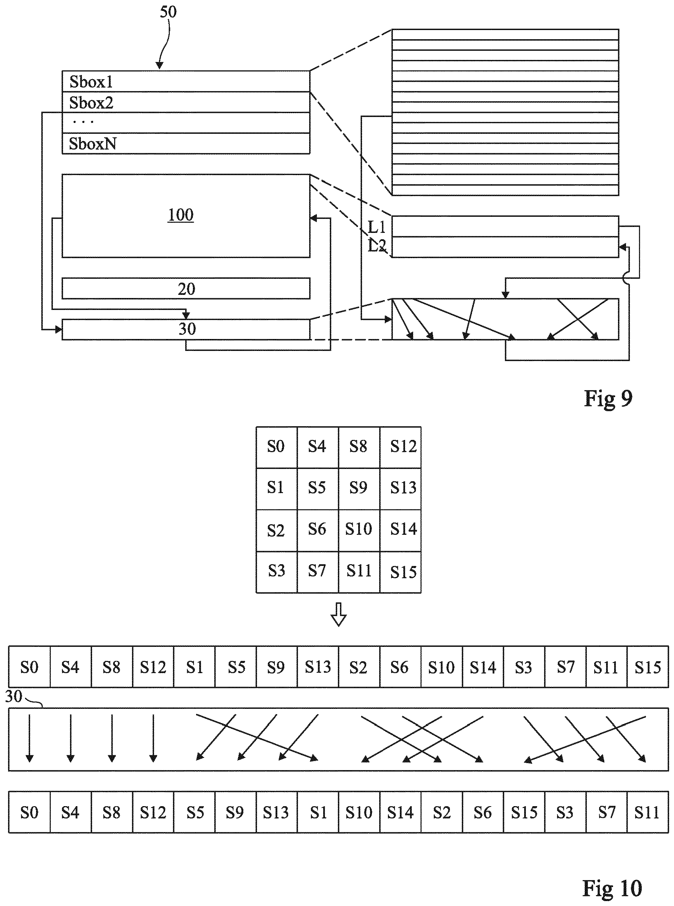

la figure 9 représente de façon schématique un exemple d'un procédé de traitement de données pouvant être mis en oeuvre par un circuit mémoire selon un mode de réalisation ;

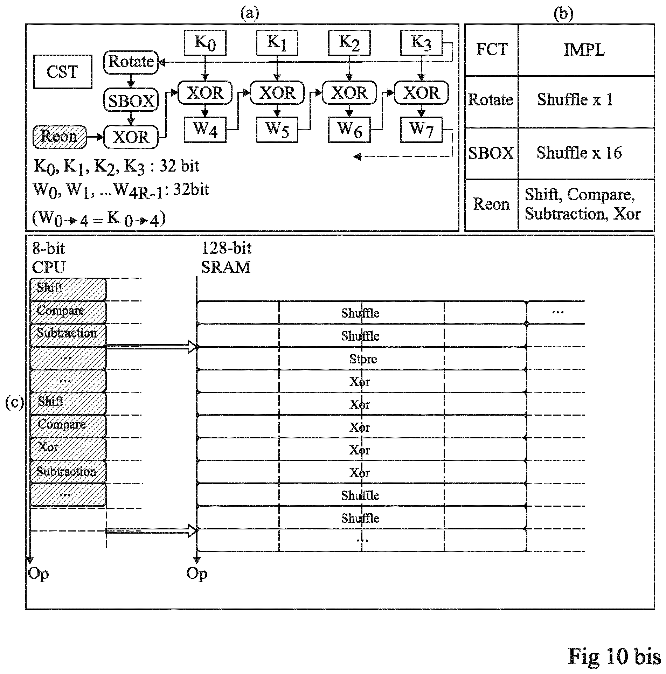

la figure 10 représente de façon schématique un autre exemple d'un procédé de traitement de données pouvant être mis en oeuvre par un circuit mémoire selon un mode de réalisation ;

La figure 10bis représente de façon schématique un autre exemple d'un procédé de traitement de données pouvant être mis en oeuvre par un circuit mémoire selon un mode de réalisation ; et

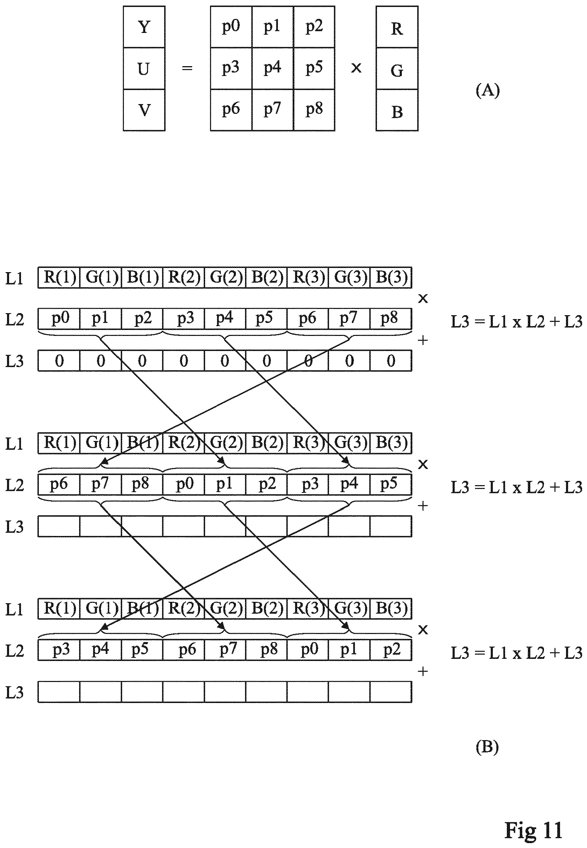

la figure 11 illustre schématiquement un autre exemple d'un procédé de traitement de données pouvant être mis en oeuvre par un circuit mémoire selon un mode de réalisation.

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier la réalisation complète d'un circuit mémoire adapté à mettre en oeuvre des opérations de calcul par activation simultanée en lecture d'une pluralité de rangées d'une matrice de cellules élémentaires n'a pas été détaillée, les modes de réalisation décrits étant compatibles avec les architectures connues de tels circuits, et notamment celles décrites dans les demandes de brevet susmentionnées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

Dans la description qui suit, les références à des signaux de niveau haut et bas doivent être interprétées de façon relative, comme correspondant à deux états distincts des signaux binaires traités par les circuits décrits. A titre d'exemple, le niveau haut des signaux correspond à des potentiels de l'ordre d'un potentiel d'alimentation haut VDD des circuits décrits (par exemple égal à VDD à 0,5 V près), et le niveau bas des signaux correspond à des potentiels de l'ordre d'un potentiel d'alimentation bas GND des circuits décrits (par exemple égal à GND à 0,5 V près).

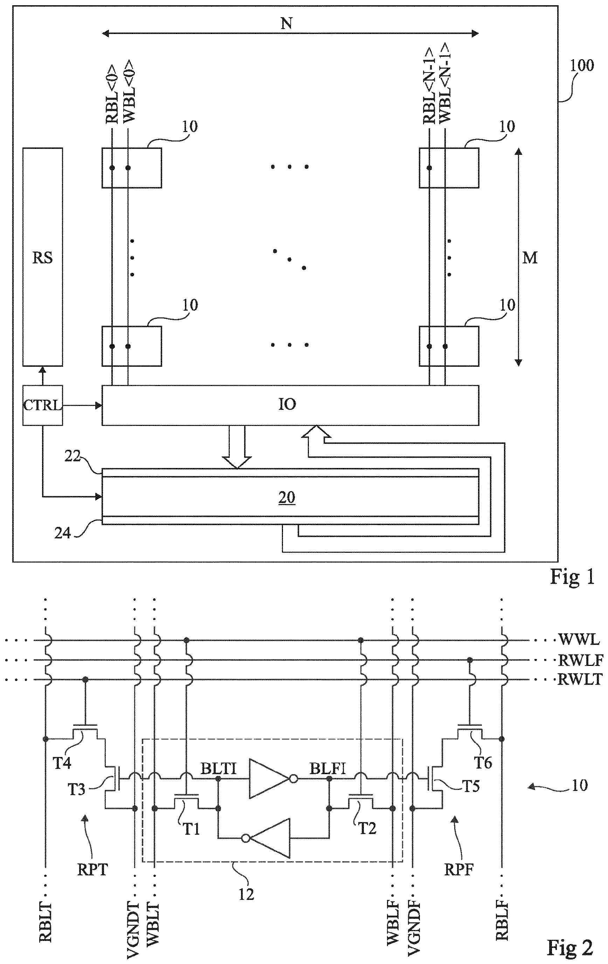

La figure 1 représente de façon schématique un exemple d'un circuit mémoire 100. L'ensemble des éléments du circuit mémoire 100 est par exemple intégré dans et sur une même puce de circuit intégré.

Le circuit mémoire 100 de la figure 1 comprend une pluralité de cellules élémentaires 10 agencées en matrice selon des rangées et des colonnes. Dans l'exemple de la figure 1, la matrice comprend M rangées et N colonnes, où M et N sont des entiers supérieurs ou égaux à 2.

Chaque cellule élémentaire 10 est adaptée à mémoriser un bit de donnée. Les cellules élémentaires 10 d'une même colonne de la matrice sont connectées à une même piste conductrice de sortie de données ou ligne de bit de lecture RBL du circuit, et à une même piste conductrice d'entrée de données ou ligne de bit d'écriture WBL du circuit, étant entendu que les cellules élémentaires 10 de colonnes distinctes sont connectées à des lignes de bit de lecture RBL distinctes et à des lignes de bit d'écriture WBL distinctes. Autrement dit, pour chaque colonne de rang j de la matrice, où j est un entier allant de 0 à N-1, le circuit mémoire 100 comprend une ligne de bit de lecture RBL<j> et une ligne de bit d'écriture WBL<j> spécifiques à la colonne, connectant entre elles les cellules de la colonne. Les lignes de bit de lecture RBL<j> et d'écriture WBL<j> s'étendent dans la direction des colonnes de la matrice, c'est-à-dire verticalement dans l'orientation de la figure 1. Les lignes de bit de lecture RBL<j> et d'écriture WBL<j> sont connectées à un même circuit d'entrée-sortie IO du circuit mémoire, par exemple disposé à une extrémité des colonnes de la matrice.

Le circuit mémoire 100 comprend de plus un circuit de sélection de rangées RS, par exemple disposé à une extrémité des rangées de la matrice.

Le circuit mémoire 100 comprend en outre un circuit de contrôle CTRL adapté à recevoir des instructions provenant d'un dispositif externe au circuit mémoire, et à commander en conséquence les cellules élémentaires 10 du circuit mémoire via le circuit de sélection de rangées RS et/ou via le circuit d'entrée-sortie IO.

Dans cet exemple, le circuit mémoire est adapté non seulement à stocker des données, mais aussi à effectuer, in-situ, lors d'accès au contenu de la mémoire, un certain nombre d'opérations logiques et/ou arithmétiques ayant pour opérandes des données stockées dans le circuit mémoire. Les résultats des calculs peuvent être transmis à des circuits externes au circuit mémoire, et/ou être réécrits dans le circuit mémoire sans transiter par des circuits externes au circuit mémoire, et notamment par un bus de données externe au circuit mémoire.

Dans l'exemple de la figure 1, le circuit mémoire 100 comprend un circuit de calcul 20, par exemple disposé à une extrémité des colonnes de la matrice, adapté à mettre en oeuvre des opérations logiques ou arithmétiques ayant pour opérandes des données mémorisées dans la matrice de stockage du circuit mémoire. Dans l'exemple représenté, le circuit de calcul 20 comprend un registre d'entrée de données 22, par exemple de dimension N, et un port de sortie de données 24, par exemple de même dimension N. Le registre d'entrée de données 22 et le port de sortie de données 24 du circuit de calcul 20 sont reliés au circuit d'entrée-sortie IO du circuit mémoire. Pour mettre en oeuvre une opération de calcul au moyen du circuit 20, le circuit de contrôle CTRL commande la lecture d'une ou plusieurs données opérandes dans la matrice de stockage du circuit mémoire et l'écriture de ces données opérandes, via le circuit d'entrée-sortie IO, dans le registre d'entrée de données 22 du circuit de calcul 20. Le circuit de contrôle CTRL commande en outre le circuit 20 pour mettre en oeuvre l'opération souhaitée. Le résultat de l'opération est fourni sur le port de sortie 24 du circuit de calcul 20, et peut être directement réécrit dans la matrice de stockage du circuit mémoire par l'intermédiaire du circuit d'entrée-sortie IO, sans transiter par des circuits externes au circuit mémoire.

La figure 2 est un schéma électrique détaillé d'un exemple d'une cellule élémentaire 10 d'un circuit mémoire du type décrit en relation avec la figure 1.

La cellule élémentaire 10 de la figure 2 est une cellule à dix transistors. Elle comprend une cellule de stockage SRAM 12 à six transistors, et deux ports de lecture RPT et RPF à deux transistors chacun. La cellule de stockage 12 comprend deux inverseurs (deux transistors chacun) montés en antiparallèle entre un premier noeud BLTI de stockage d'un bit de donnée, et un deuxième noeud BLFI de stockage d'un bit de donnée complémentaire du bit stocké sur le noeud BLTI. La cellule de stockage 12 comprend en outre un premier transistor d'accès T1, reliant, par ses noeuds de conduction, le noeud BLTI à une piste conductrice WBLT appelée ligne de bit d'écriture, et un deuxième transistor d'accès T2, reliant, par ses noeuds de conduction, le noeud BLFI à une piste conductrice WBLF appelée ligne de bit d'écriture complémentaire. Les grilles des transistors T1 et T2 sont reliées à une même piste conductrice de contrôle d'écriture WWL. Le port de lecture RPT comprend deux transistors T3 et T4 montés en série, via leurs noeuds de conduction, entre une piste conductrice VGNDT d'application d'un potentiel de référence et une piste conductrice de sortie RBLT appelée ligne de bit de lecture. Le transistor T3 est situé côté piste VGNDT et a sa grille reliée au noeud BLTI, et le transistor T4 est situé côté piste RBLT et a sa grille reliée à une piste conductrice de contrôle de lecture RWLT. Le port de lecture RPF comprend deux transistors T5 et T6 montés en série, via leurs noeuds de conduction, entre une piste conductrice VGNDF d'application d'un potentiel de référence et une piste conductrice de sortie RBLF appelée ligne de bit de lecture complémentaire. Le transistor T5 est situé côté piste VGNDF et a sa grille reliée au noeud BLFI, et le transistor T6 est situé côté piste RBLF et a sa grille reliée à une piste conductrice de contrôle de lecture RWLF. Dans cet exemple, les transistors T1, T2, T3, T4, T5, T6 sont des transistors MOS à canal N.

Dans un circuit mémoire du type décrit en relation avec la figure 1, les cellules élémentaires d'une même rangée du circuit sont interconnectées via leurs pistes conductrices WWL, respectivement RWLF, respectivement RWLT, et les cellules élémentaires d'une même colonne du circuit sont interconnectées via leurs pistes conductrices RBLT, respectivement VGNDT, respectivement WBLT, respectivement WBLF, respectivement VGNDF, respectivement RBLF. En d'autres termes, les cellules d'une même rangée partagent une même piste conductrice WWL, une même piste conductrice RWLF, et une même piste conductrice RWLT, et les cellules d'une même colonne partagent une même piste conductrice RBLT, une même piste conductrice VGNDT, une même piste conductrice WBLT, une même piste conductrice WBLF, une même piste conductrice VGNDF, et une même piste conductrice RBLF. Les cellules de rangées distinctes ont quant à elles des pistes conductrices WWL, respectivement RWLF, respectivement RWLT, distinctes, et les cellules de colonnes distinctes ont des pistes conductrices RBLT, respectivement VGNDT, respectivement WBLT, respectivement WBLF, respectivement VGNDF, respectivement RBLF, distinctes. A titre d'exemple, les pistes conductrices WWL, RWLF et RWLT sont connectées au circuit de sélection de rangées RS du circuit mémoire, et les pistes conductrices RBLT, VGNDT, WBLT, WBLF, VGNDF et RBLF sont connectées au circuit d'entrée-sortie IO du circuit mémoire.

A titre d'exemple, la ligne de bit de lecture RBLT et la ligne de bit d'écriture WBLT de la cellule 10 de la figure 2 correspondent respectivement à une ligne de bit de lecture RBL et à une ligne de bit d'écriture WBL du circuit mémoire de la figure 1. Par souci de simplification, dans les figures de circuit mémoire de la présente demande (les figures 1, 3 et 7), une seule ligne de bit de lecture et une seule ligne de bit d'écriture ont été représentées par cellule élémentaire du circuit mémoire. En pratique, les modes de réalisation décrits peuvent être mis en oeuvre soit dans des circuits mémoire constitués de cellules élémentaires à une seule ligne de bit de lecture et une seule ligne de bit d'écriture, soit dans des circuits mémoire constitués de cellules élémentaires à deux lignes de bit de lecture complémentaires, par exemple du type décrit en relation avec la figure 2.

Pour réaliser une lecture d'une cellule élémentaire 10 du type décrit en relation avec la figure 2 via son port de lecture RPT, la ligne de bit de lecture RBLT de la cellule est d'abord préchargée à un niveau haut, par exemple à la tension d'alimentation VDD du circuit mémoire. La piste conductrice VGNDT est quant à elle maintenue à un niveau bas, par exemple au potentiel bas GND par rapport auquel est référencée la tension d'alimentation VDD du circuit mémoire. Le transistor T4 de la cellule est ensuite rendu passant par application d'un signal de niveau haut sur la piste conductrice RWLT de la cellule. Après l'activation du transistor T4, la piste conductrice RBLT se décharge si le potentiel du noeud BLTI est à un niveau haut (transistor T3 passant), et reste sensiblement à son niveau de précharge si le potentiel BLTI est à un niveau bas (transistor T3 bloqué). La lecture du potentiel de la piste RBLT via le circuit d'entrée-sortie IO du circuit mémoire permet de déterminer la valeur du bit de donnée stocké dans la cellule élémentaire. La cellule peut en outre être lue sensiblement de la même manière via son port de lecture RPF.

Pour mettre en oeuvre des opérations de calcul, dans un circuit mémoire constitué de cellules élémentaires 10 du type décrit en relation avec la figure 2, le circuit de contrôle CTRL du circuit mémoire est adapté à activer simultanément en lecture (via le circuit de sélection de rangées RS) deux, ou un nombre supérieur à deux, de cellules élémentaires d'une même colonne du circuit mémoire, via les ports d'accès RPT, et/ou via les ports d'accès RPF de ces cellules.

A titre d'exemple illustratif, on considère que deux cellules élémentaires 10 d'une même colonne sont activées simultanément en lecture via leurs ports RPT et RPF. Pour cela, après avoir préchargé à un niveau haut les lignes de bit de lecture RBLT et RBLF de la colonne et mis à un niveau bas les pistes conductrices de référence VGNDT et VGNDF de la colonne, les transistors de sélection T4 et T6 des deux cellules sélectionnées sont simultanément rendus passant, via les pistes conductrices de commande RWLT et RWLF des rangées correspondantes. On désigne respectivement par A et B les valeurs binaires mémorisées sur les noeuds BLTI des deux cellules considérées. Les valeurs binaires complémentaires NA et NB sont alors stockées sur les noeuds BLFI respectifs des deux cellules. La piste conductrice de sortie RBLT de la colonne reste à son niveau haut de précharge uniquement si les deux valeurs A et B sont à un niveau bas. Ainsi, le niveau lu sur la piste de sortie RBLT de la colonne à la fin de l'opération de lecture correspond au résultat NA.NB d'une opération de calcul logique NON OU entre les deux cellules mémoire sélectionnées. De plus, la piste conductrice de sortie RBLF de la colonne reste à son niveau haut de précharge uniquement si les deux valeurs A et B sont à un niveau haut. Ainsi, le niveau lu sur la piste de sortie RBLF de la colonne à la fin de l'opération de lecture correspond au résultat A.B d'une opération de calcul logique ET entre les deux cellules mémoire sélectionnées.

En activant simultanément en lecture un nombre supérieur à deux de cellules d'une même colonne, les opérations de calcul susmentionnées peuvent être mises en oeuvre avec un nombre d'opérandes supérieur à 2. De plus, en activant simultanément en lecture plusieurs colonnes du circuit mémoire, ces opérations de calcul peuvent être mises en oeuvre sur des mots de plusieurs bits.

Ainsi, des opérations de calcul logique de base peuvent être mises en oeuvre directement dans la mémoire, sans avoir à faire transiter les données par une unité arithmétique et logique externe au circuit.

Pour permettre la réécriture du résultat d'une opération de calcul sans faire transiter la donnée calculée par des circuits externes au circuit mémoire, et notamment par un bus de données externe au circuit mémoire, le circuit d'entrée-sortie IO du circuit mémoire peut comprendre un circuit interne de redirection (non détaillé) permettant de relier la ou les lignes de bit de lecture de chaque colonne du circuit mémoire à un noeud d'entrée de données de la colonne et/ou d'une autre colonne de la matrice, par exemple à la piste conductrice WBLT et/ou à la piste conductrice WBLF de la colonne ou d'une autre colonne de la matrice dans une architecture du type décrit en relation avec la figure 2.

Pour mettre en oeuvre des opérations de calcul plus complexes, par exemple des opérations arithmétiques, les données opérandes peuvent être transmises au circuit de calcul 20. Pour cela, le circuit interne de redirection du circuit d'entrée-sortie IO peut être configuré pour relier les lignes de bit de lecture du circuit mémoire à des noeuds d'entrée du registre d'entrée de données 22 du circuit de calcul 20. Une fois l'opération réalisée, le circuit interne de redirection du circuit d'entrée-sortie IO peut être configuré pour relier les lignes de bit d'écriture du circuit mémoire à des noeuds de sortie du port de sortie de données 24 du circuit de calcul 20 de façon à permettre la réécriture du résultat de l'opération de calcul sans faire transiter la donnée calculée par des circuits externes au circuit mémoire, et notamment par un bus de données externe au circuit mémoire.

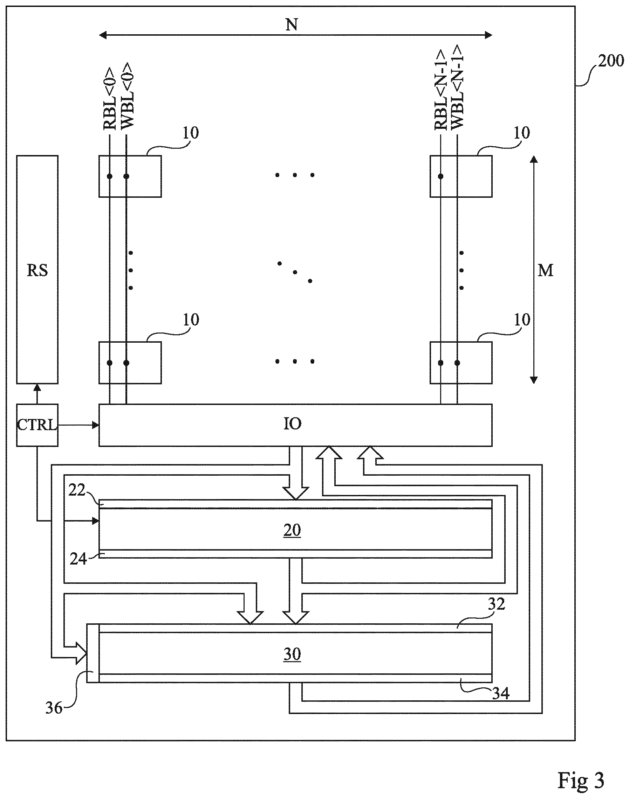

La figure 3 représente de façon schématique un exemple d'un circuit mémoire 200 selon un mode de réalisation. Comme dans l'exemple de la figure 1, l'ensemble des éléments du circuit mémoire 200 peut être intégré dans et sur une même puce semiconductrice.

Le circuit mémoire 200 de la figure 3 comprend les mêmes éléments que le circuit mémoire 100 de la figure 1, agencés sensiblement de la même manière.

Le circuit mémoire 200 comprend en outre un circuit de permutation 30. Le circuit de permutation 30 comprend un registre d'entrée de données 32 de dimension K, c'est-à-dire adapté à recevoir simultanément (en parallèle) et à mémoriser K bits de données, et un port de sortie de données 34 de même dimension K, c'est-à-dire adapté à fournir simultanément (en parallèle) K bits de données. A titre d'exemple, la dimension K du circuit de permutation 30 est égale au nombre N de colonnes de la matrice de cellules de stockage du circuit mémoire. Le circuit de permutation 30 comprend en outre un registre de configuration 36. Le circuit de permutation est adapté à fournir sur son port de sortie les K bits mémorisés dans son registre d'entrée de données, permutés selon une permutation définie en fonction de l'état de son registre de configuration 36.

Par permutation, on entend ici que les K bits d'entrée du circuit 30 sont recopiés en sortie du circuit 30, mais dans un ordre différent. Le nombre total de permutations possible pour un vecteur d'entrée de K bits est égal à K! (K factorielle), soit K*(K-1)*(K-2)* ... *2*1. Le circuit de permutation 30 est par exemple configurable, via son registre de configuration 36, pour mettre en oeuvre l'une quelconque des K! permutations possibles.

Le registre d'entrée de données 32, le port de sortie de données 34 et le registre de configuration 36 du circuit de permutation 30 sont reliés au circuit d'entrée-sortie IO du circuit mémoire. Pour mettre en oeuvre une opération de permutation au moyen du circuit 30, le circuit de contrôle CTRL commande la lecture d'une donnée d'entrée dans la matrice de stockage du circuit mémoire, l'écriture de cette donnée, via le circuit d'entrée-sortie IO, dans le registre d'entrée de données 32 du circuit de permutation 30, la lecture d'une donnée de configuration dans la matrice de stockage du circuit mémoire, et l'écriture de cette donnée, via le circuit d'entrée-sortie IO, dans le registre de configuration 36 du circuit de permutation 30. Pour cela, le circuit interne de redirection du circuit d'entrée-sortie IO peut être configuré pour relier les lignes de bit de lecture du circuit mémoire à des noeuds d'entrée du registre d'entrée de données 32 du circuit de permutation 30 et/ou à des noeuds d'entrée du registre de configuration 36 du circuit de permutation 30. Le résultat de la permutation est fourni sur le port de sortie 34 du circuit 30, et peut être directement réécrit dans la matrice de stockage du circuit mémoire par l'intermédiaire du circuit d'entrée-sortie IO, sans transiter par des circuits externes au circuit mémoire. Pour cela, le circuit interne de redirection du circuit d'entrée-sortie IO peut être configuré pour relier les lignes de bit d'écriture du circuit mémoire à des noeuds de sortie du port de sortie de données 34 du circuit de permutation 30. La durée de l'opération de permutation proprement dite est une durée fixe ou sensiblement fixe (les délais de propagation pouvant bien entendu varier légèrement en fonction des conditions de puissance, de tension et/ou de température, et, dans une moindre mesure, en fonction des contenus respectifs des registres en fonction de l'architecture de réalisation du circuit de routage). Cette durée est par exemple inférieure ou égale à un cycle d'une horloge de cadencement des opérations logiques ou arithmétiques réalisées dans le circuit mémoire. Pour cela, le circuit de permutation 30 est un circuit à architecture parallèle, de type circuit de routage configurable. Ceci permet de faciliter considérablement le travail de compilation d'un programme destiné à être exécuté sur un circuit intégré comprenant au moins un processeur et un circuit mémoire dit intelligent, du type décrit en relation avec la figure 3. En effet, pour effectuer une opération de permutation d'un mot de dimension K, seule une donnée de configuration de la permutation est à mémoriser.

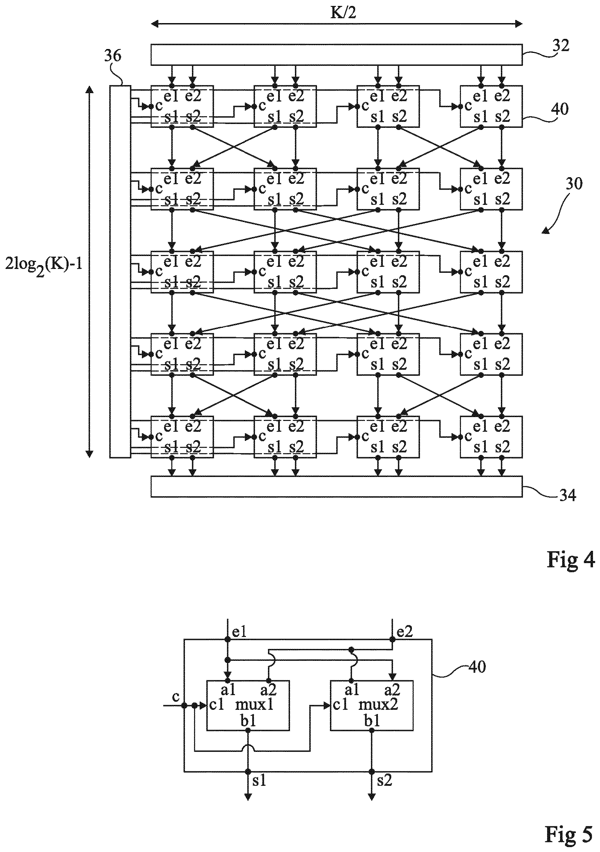

La figure 4 représente plus en détail un exemple de réalisation du circuit de permutation 30 du circuit mémoire de la figure 3. Dans cet exemple, on considère, à titre d'exemple illustratif, un circuit de permutation de dimension K = 8, c'est-à-dire dans lequel les registres d'entrée 32 et de sortie 34 sont chacun de dimension K = 8. L'homme de l'art saura généraliser cet exemple à la réalisation d'un circuit de permutation de dimension K quelconque, où K = $2^H$ (deux puissance H) et H est un entier positif. On notera que dans le cas où la dimension D des données de la mémoire n'est pas une puissance de deux, on pourra choisir K supérieur à D, par exemple égal à la première puissance de deux supérieure à D (K = $2^H$ avec H tel que $2^{H-1} < D < K = 2^H$), et compléter les données de la mémoire par des 0 pour obtenir des mots d'entrée de dimension K.

Dans l'exemple de la figure 4, le circuit de permutation est réalisé au moyen d'un réseau de Benes constitué de $(K/2)*(2*\log_2(K)-1)$ cellules élémentaires de permutation 40. Dans l'exemple de la figure 4, les cellules élémentaires de permutation 40 sont agencées en matrice selon $2*\log_2(K)-1$ rangées et K/2 colonnes.

Chaque cellule élémentaire de permutation 40 comprend deux noeuds d'entrée e1 et e2, deux noeuds de sortie s1 et s2, et un noeud de configuration c. Chaque cellule élémentaire 40 est adaptée à recopier sur ses noeuds de sortie s1 et s2 les signaux appliqués respectivement sur ses noeuds d'entrée e1 et e2, ou à recopier sur ses noeuds de sortie s1 et s2 les signaux appliqués respectivement sur ses noeuds d'entrée e2 et e1, en fonction de l'état du signal appliqué sur son noeud de configuration c.

Les K noeuds d'entrée e1, e2 des cellules 40 de la rangée de rang l=1, avec l entier allant de 1 à $2*\log_2(K)-1$, sont reliés, de préférence connectés, respectivement aux K noeuds de stockage du registre d'entrée de données 32 du circuit de permutation. Les K noeuds de sortie s1, s2 des cellules 40 de la rangée de rang $l=2*\log_2(K)-1$ sont reliés, de préférence connectés, respectivement aux K noeuds de sortie du port de sortie 34 du circuit de permutation. Dans cet exemple, le registre de configuration 36 comprend $(K/2)*(2*\log_2(K)-1)$ noeuds de stockage reliés respectivement aux noeuds de configuration c des $(K/2)*(2*\log_2(K)-1)$ cellules 40 du circuit de permutation.

Dans chaque rangée de rang l=1 à $l=\log_2(K)-1$, les cellules de la rangée sont réparties par groupes de $n=2^l$ cellules voisines dont les noeuds de sortie s1, s2 sont reliés aux noeuds d'entrée e1, e2 des cellules de la rangée suivante (la rangée de rang l+1) selon une liaison en croix définie comme suit :

- chacune des n/2 premières cellules du groupe a son noeud de sortie s1 relié, de préférence connecté, au noeud e1 de la cellule de même position dans la rangée l+1 ;
- chacune des n/2 dernières cellules du groupe a son noeud de sortie s2 relié, de préférence connecté, au noeud e2 de la cellule de même position dans la rangée l+1 ;
- chacune des n/2 premières cellules du groupe a son noeud de sortie s2 relié, de préférence connecté, au noeud e1 de la cellule de position $m+2^{l-1}$ dans la rangée l+1 (avec m entier allant de 1 à K/2 désignant la position de la cellule considérée dans la rangée de rang l) ; et
- chacune des n/2 dernières cellules du groupe a son noeud de sortie s1 relié, de préférence connecté, au noeud e2 de la cellule de position $m-2^{l-1}$ dans la rangée l+1.

Le réseau est symétrique par rapport à la rangée centrale de rang $l=\log_2(K)$, c'est-à-dire que, dans chaque rangée de rang $l=\log_2(K)$ à $l=2*\log_2(K)-2$, les cellules de la rangée sont réparties par groupes de $n=2^{(2*\log_2(K)-1-l)}$ cellules voisines dont les noeuds de sortie s1, s2 sont reliés aux noeuds d'entrée e1, e2 des cellules de la rangée suivante (la rangée (l+1)) selon une liaison croisée définie comme suit :

- chacune des n/2 premières cellules du groupe a son noeud de sortie s1 relié, de préférence connecté, au noeud e1 de la cellule de même position dans la rangée l+1 ;
- chacune des n/2 dernières cellules du groupe a son noeud de sortie s2 relié, de préférence connecté, au noeud e2 de la cellule de même position dans la rangée l+1 ;
- chacune des n/2 premières cellules du groupe a son noeud de sortie s2 relié, de préférence connecté, au noeud e1 de la cellule de position $m+2^{(2*\log_2(K)-2-l)}$ dans la rangée l+1 ; et
- chacune des n/2 dernières cellules du groupe a son noeud de sortie s1 relié, de préférence connecté, au noeud e2 de la cellule de position $m-2^{(2*\log_2(K)-2-l)}$ dans la rangée l+1.

La figure 5 représente un exemple d'une cellule élémentaire de permutation 40 du circuit de permutation de la figure 4.

La cellule 40 de la figure 5 comprend deux multiplexeurs mux1 et mux2, par exemple identiques, de deux entrées vers une sortie. Chacun des multiplexeurs mux1 et mux2 comprend deux noeuds d'entrée a1 et a2, un noeud de sortie b1, et un noeud de configuration c1, et est adapté à fournir sur son noeud de sortie b1 l'un ou l'autre des signaux appliqués sur ses noeuds d'entrée a1 et a2, en fonction de l'état du signal appliqué sur son noeud de configuration c1.

Le noeud d'entrée e1 de la cellule 40 est connecté au noeud d'entrée a1 du multiplexeur mux1 et au noeud d'entrée a2 du multiplexeur mux2. Le noeud d'entrée e2 de la cellule 40 est connecté au noeud d'entrée a2 du multiplexeur mux1 et au noeud d'entrée a1 du multiplexeur mux2. Le noeud de configuration c de la cellule 40 est connecté aux noeuds de configuration c1 des multiplexeurs mux1 et mux2.

En fonction de l'état du signal appliqué sur son noeud de configuration c, la cellule 40 fournit sur son noeud s1 le signal appliqué sur son noeud e1 et fournit sur son noeud s2 le signal appliqué sur son noeud e2, ou fournit sur son noeud s1 le signal appliqué sur son noeud e2 et fournit sur son noeud s2 le signal appliqué sur son noeud e1.

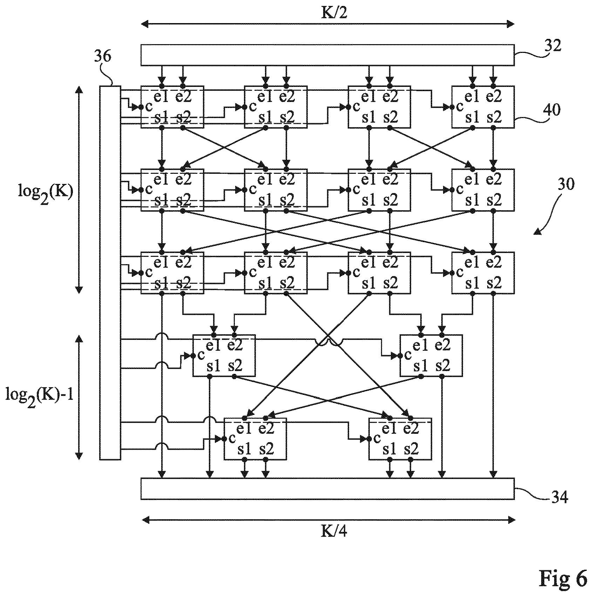

La figure 6 représente un autre exemple de réalisation du circuit de permutation 30 du circuit mémoire de la figure 3. Comme dans l'exemple de la figure 4, on considère ici, à titre d'exemple illustratif, un circuit de permutation de dimension K = 8, c'est-à-dire dans lequel les registres d'entrée 32 et de sortie 34 sont chacun de dimension K=8.

Dans l'exemple de la figure 6, le circuit de permutation est constitué d'un réseau de 16 cellules élémentaires de permutation 40, par exemple identiques ou similaires à celles du circuit de permutation de la figure 4. Dans l'exemple de la figure 6, les cellules élémentaires de permutation 40 sont agencées selon 5 rangées, les rangées de rang l=1 à l= 3 comportant chacune 4 cellules élémentaires 40, et les rangées de rang l= 4 à l=5 comportant chacune 2 cellules élémentaires 40.

Les K noeuds d'entrée e1, e2 des cellules 40 de la rangée de rang l=1 sont reliés, de préférence connectés, respectivement aux K noeuds de stockage du registre d'entrée de données 32 du circuit de permutation. Dans cet exemple, le registre de configuration 36 comprend 16 noeuds de stockage reliés respectivement aux noeuds de configuration c des 16 cellules 40 du circuit de permutation.

Comme dans l'exemple de la figure 4, dans chaque rangée de rang l=1 à l=2, les cellules de la rangée sont réparties par groupes de $n=2^l$ cellules voisines dont les noeuds de sortie s1, s2 sont reliés aux noeuds d'entrée e1, e2 des cellules de la rangée suivante (la rangée de rang l+1) selon une liaison en croix définie comme suit :

- chacune des n/2 premières cellules du groupe a son noeud de sortie s1 relié, de préférence connecté, au noeud e1 de la cellule de même position dans la rangée l+1 ;
- chacune des n/2 dernières cellules du groupe a son noeud de sortie s2 relié, de préférence connecté, au noeud e2 de la cellule de même position dans la rangée l+1 ;
- chacune des n/2 premières cellules du groupe a son noeud de sortie s2 relié, de préférence connecté, au noeud e1 de la cellule de position $m+2^{l-1}$ dans la rangée l+1 ; et
- chacune des n/2 dernières cellules du groupe a son noeud de sortie s1 relié, de préférence connecté, au noeud e2 de la cellule de position $m-2^{l-1}$ dans la rangée l+1.

A la différence de l'exemple de la figure 4, le réseau de la figure 6 n'est pas symétrique par rapport à la rangée centrale de rang $l=\log_2(K)=3$. Dans l'exemple de la figure 6, la première cellule de la rangée de rang l=4 a son noeud e1 relié, de préférence connecté, au noeud s2 de la première cellule de la rangée de rang l=3, et son noeud e2 relié, de préférence connecté, au noeud s1 de la deuxième cellule de la rangée de rang l=3. La deuxième cellule de la rangée de rang l=4 a son noeud e1 relié, de préférence connecté, au noeud s2 de la troisième cellule de la rangée de rang l=3, et son noeud e2 relié, de préférence connecté, au noeud s1 de la quatrième cellule de la rangée de rang l=3. La première cellule de la rangée de rang l=5 a son noeud e1 relié, de préférence connecté, au noeud s1 de la troisième cellule de la rangée de rang l=3, et son noeud e2 relié, de préférence connecté, au noeud s1 de la deuxième cellule de la rangée de rang l=4. La deuxième cellule de la rangée de rang l=5 a son noeud e1 relié, de préférence connecté, au noeud s2 de la première cellule de la rangée de rang l=4, et son noeud e2 relié, de préférence connecté, au noeud s2 de la deuxième cellule de la rangée de rang l=3. Les 8 noeuds de sortie du port de sortie 34 du circuit de permutation sont reliés, de préférence connectés, respectivement au noeud s1 de la première cellule de la rangée de rang l=3, au noeud s1 de la première cellule de la rangée de rang l=4, au noeud s1 de la première cellule de la rangée de rang l=5, au noeud s2 de la première cellule de la rangée de rang l=5, au noeud s1 de la deuxième cellule de la rangée de rang l=5, au noeud s2 de la deuxième cellule de la rangée de rang l=5, au noeud s2 de la deuxième cellule de la rangée de rang l=4, et au noeud s2 de la quatrième cellule de la rangée de rang l=3.

Un avantage du circuit de permutation de la figure 6 est qu'il comporte un nombre de cellules élémentaires de permutation 40 inférieur à celui de la figure 4. Ceci permet de réduire l'encombrement et la consommation électrique du circuit, tout en permettant de mettre en oeuvre l'ensemble des K! permutations possibles pour un vecteur d'entrée de dimension K. De plus, ceci permet de réduire la dimension du registre de configuration 36 du circuit de permutation.

Plus généralement, d'autres agencements de circuits de permutations peuvent être prévus, utilisant un nombre de cellules élémentaires pouvant aller de $\log_2(K!+1)$ à $(K/2)*(2*\log_2(K)-1)$.

La figure 7 représente de façon schématique un autre exemple d'un circuit mémoire 300 selon un mode de réalisation. Comme dans l'exemple de la figure 3, l'ensemble des éléments du circuit mémoire 300 peut être intégré dans et sur une même puce semiconductrice.

Le circuit mémoire 300 de la figure 7 diffère du circuit mémoire 200 de la figure 3 principalement en ce qu'il comprend, en plus de la mémoire principale formée par la matrice de cellules de stockage 10, une mémoire additionnelle 50, par exemple une mémoire non volatile, destinée à stocker les données de configuration du circuit de permutation 30. Ainsi, dans l'exemple de la figure 7, le registre de configuration 36 du circuit de permutation 30 est relié non pas au circuit d'entrée-sortie IO de la mémoire principale comme dans l'exemple de la figure 3, mais à un port de sortie (non détaillé sur la figure 7) de la mémoire additionnelle 50.

Dans l'exemple de la figure 7, pour mettre en oeuvre une opération de permutation au moyen du circuit 30, le circuit de contrôle CTRL commande la lecture d'une donnée d'entrée dans la mémoire principale, l'écriture de cette donnée, via le circuit d'entrée-sortie IO de la mémoire principale, dans le registre d'entrée de données 32 du circuit de permutation 30, la lecture d'une donnée de configuration dans la mémoire additionnelle 50, et l'écriture de cette donnée dans le registre de configuration 36 du circuit de permutation 30. Le résultat de la permutation est fourni sur le port de sortie 34 du circuit de permutation 30, et peut être directement réécrit dans la mémoire principale par l'intermédiaire du circuit d'entrée-sortie IO de la mémoire principale, sans transiter par des circuits externes au circuit mémoire.

La figure 8 illustre plus en détail un exemple de réalisation de la mémoire additionnelle 50 dans le circuit mémoire de la figure 7. Dans cet exemple, on considère le cas où le circuit de permutation 30 est un circuit du type décrit en relation avec la figure 4. La mémoire additionnelle 50 est divisée en $2*\log_2(K)-1$ modules MOD de p rangées par K/2 colonnes chacun, p étant un entier inférieur ou égal à K! correspondant au nombre de permutations mémorisées. Chacun des $2*\log_2(K)-1$ modules MOD de p rangées par K/2 colonnes peut comprendre un port de sortie de dimension K/2, c'est-à-dire adapté à fournir simultanément, sur K/2 noeuds de sortie distincts, les K/2 bits d'une rangée du module. Chacun des $2*\log_2(K)-1$ modules MOD de p rangées par K/2 colonnes a ses K/2 noeuds de sortie reliés respectivement aux K/2 noeuds de configuration c des cellules élémentaires de permutation 40 de l'une des $2*\log_2(K)-1$ rangées de K/2 cellules 40 du réseau de permutation, étant entendu que les noeuds de configuration c des cellules 40 de rangées distinctes du réseau de permutation sont reliés respectivement à des noeuds de sortie de modules MOD distincts de la mémoire additionnelle 50.

Dans chaque module MOD de la mémoire additionnelle 50, chacune des p rangées du module mémorise une configuration de la rangée correspondante du circuit de permutation 30, correspondant à l'une des K! configurations possibles du circuit de permutation 30. Un circuit de sélection de rangée (non détaillé sur la figure 8), par exemple commun aux $2*\log_2(K)-1$ modules MOD de la mémoire additionnelle 50, peut être prévu pour choisir la configuration souhaitée du circuit de permutation 30.

Par rapport au circuit mémoire de la figure 1, un avantage des modes de réalisation décrits en relation avec les figures 3 à 8bis est qu'ils permettent de mettre des opérations de permutation directement dans le circuit mémoire, sans avoir à faire transiter les données à permuter par des circuits externes et notamment par des bus de données externes au circuit mémoire. De nombreux procédés de traitement de données mettant en oeuvre des permutations peuvent ainsi être mis en oeuvre en totalité ou partie par un tel circuit mémoire, par exemple des procédés de cryptage de données, des procédés de traitement d'images, des algorithmes d'inférence de réseaux de neurones artificiels, etc.

La mémoire additionnelle 50 est par exemple une mémoire non volatile, par exemple une mémoire résistive, par exemple de type RRAM ou ReRAM, formée au-dessus d'un substrat semiconducteur, par exemple en silicium, dans et sur lequel sont formés la mémoire principale et les circuits de calcul 20 et de permutation 30 (Shuffle Block) du circuit mémoire. Ceci permet un gain significatif en densité dans la mesure où le stockage des données de configuration du circuit de permutation n'entraîne alors pas d'augmentation de la surface totale du circuit mémoire.

La figure 8bis illustre de façon schématique un exemple d'un circuit mémoire du type décrit en relation avec la figure 7, dans lequel la mémoire additionnelle 50 est intégrée au-dessus d'un substrat semiconducteur, par exemple en silicium, dans et sur lequel sont notamment formés la mémoire principale et les circuits de calcul 20 et de permutation 30 du circuit mémoire. Dans cet exemple, la mémoire additionnelle 50 est divisée en plusieurs modules MOD tel que décrit en relation avec la figure 8.

Comme l'illustre la vue (a) de la figure 8bis, un premier plan comprend la mémoire principale (SRAM ARRAY), comprenant les cellules 10 (non visibles sur la figure 8bis), ainsi que ses circuits périphériques, comprenant notamment le circuit d'entrée/sortie IO, les circuits de calcul et de permutation 20, 30, et le circuit de contrôle CTRL. La mémoire principale stocke les données de calcul 81 (COMPUT DATA). Un deuxième plan superposé au premier plan comprend la mémoire additionnelle 50 (NVM MEMORY), qui stocke les données de configuration 83 (CONFIG DATA) du circuit de permutation 30, ainsi qu'éventuellement d'autres données, étendant ainsi la capacité de stockage du système. Ceci facilite en outre la connexion de la mémoire additionnelle aux cellules élémentaires 40 du circuit de permutation 30, notamment dans le cas d'une configuration du type décrit en relation avec la figure 8, comme l'illustre la vue (b) de la figure 8bis. Dans cette configuration, la transmission des données de configuration au circuit de permutation est plus aisée et plus rapide que lorsque les données de configuration sont stockées dans la mémoire principale. En particulier, l'opération de lecture des mots de configuration stockés dans la mémoire additionnelle 50 peut être synchronisée ou concomitante avec l'opération de lecture des données à permuter stockées dans la mémoire principale. Pour cela, plusieurs solutions peuvent être envisagées. Par exemple, l'opération de lecture de la mémoire additionnelle 50 peut être accélérée en utilisant deux cellules élémentaires de stockage pour stocker un bit de donnée, sans utiliser d'amplificateur de lecture. A titre de variante, la fréquence de cadencement de la mémoire principale (qui effectue des opérations logiques et arithmétiques) peut aisément être abaissée pour correspondre à la fréquence de lecture de la mémoire additionnelle 50. Dans une autre variante, les opérations de lecture dans la mémoire additionnelle 50 peuvent être anticipées, les valeurs lues étant alors stockées dans des registres.

Comme l'illustre la vue (c) de la figure 8bis, une opération de permutation peut être effectuée en quatre étapes de base :

- une étape 1 (Read Config) de lecture des données de configuration dans la mémoire additionnelle 50, et de configuration du circuit de permutation 30 au moyen de ces données ;
- une étape 2 (Read Data) de lecture des données d'entrée du circuit de permutation dans la mémoire principale ;
- une étape 3 (Shuffle Data) de permutation des bits d'entrée à travers le circuit de permutation ; et
- une étape 4 (Write Data) de réécriture des données permutées dans la mémoire principale.

A titre d'exemple, un circuit mémoire du type décrit en relation avec les figures 3 à 8bis peut être utilisé pour mettre en oeuvre un procédé de chiffrement de données de type AES (de l'anglais "Advanced Encryption Standard" - standard de chiffrement avancé). En effet, le standard AES comprend au moins deux étapes de permutation de données, pouvant être mises en oeuvre par un tel circuit mémoire.

Plus particulièrement, le standard AES comprend une étape appelée SubBytes, au cours de laquelle une donnée d'entrée, sous la forme d'un vecteur de plusieurs mots de 8 bits chacun (ou octets), subit une série de plusieurs permutations successives, choisie parmi un ensemble de plusieurs séries de permutations, appelées Sbox. Les différentes configurations du circuit de permutation 30, correspondant aux différentes séries de permutation ou Sbox, peuvent être stockées dans le circuit mémoire, dans la mémoire principale dans l'exemple de la figure 3 ou dans la mémoire additionnelle dans l'exemple de la figure 7.

La figure 9 est un schéma bloc représentant de façon schématique un exemple de mise en oeuvre de l'étape SubBytes du standard AES dans un circuit mémoire du type décrit ci-dessus.

Le standard AES comprend en outre une étape appelée ShiftRows, au cours de laquelle les deuxième, troisième et quatrième rangées d'une matrice de 4x4 octets sont décalées circulairement respectivement de 1 octet, de deux octets, et de trois octets. Pour réaliser cette opération, les données de la matrice d'entrée sont par exemple agencées sous la forme d'un vecteur rangée de 16 octets correspondant à une concaténation des quatre rangées de la matrice. Ce vecteur est appliqué en entrée du circuit de permutation 30. Le circuit de permutation 30 est configuré pour fournir un vecteur de sortie de 16 octets correspondant à une concaténation de la première rangée de la matrice d'entrée, de la deuxième rangée de la matrice d'entrée décalée circulairement de 1 octet, de la troisième rangée de la matrice d'entrée décalée circulairement de 2 octets, et de la quatrième rangée de la matrice d'entrée décalée circulairement de trois octets. La configuration correspondante du circuit de permutation 30 peut être stockée dans le circuit mémoire, dans la mémoire principale dans l'exemple de la figure 3, ou dans la mémoire additionnelle dans l'exemple de la figure 7.

La figure 10 illustre de façon schématique un exemple de mise en oeuvre de l'étape ShiftRows du standard AES dans un circuit mémoire du type décrit ci-dessus.

Le standard AES comprend en outre une fonction d'expansion de clé ("Key Expansion function" en langue anglaise). Cette fonction permet de générer, à partir d'une clé initiale de 128 bits, une clé étendue composée de 10 clés circulaires ("round key" en langue anglaise) de 128 bits chacune.

La figure 10bis illustre schématiquement l'algorithme. Sur la vue (a) de la figure 10bis, on a représenté une vue d'ensemble de l'algorithme. Le calcul est effectué sur des mots de clé de 32 bits, les références $K_0$, $K_1$, $K_2$, $K_3$ désignant les quatre mots de la clé initiale et les références $W_0$, $W_1$, ..., $W_{4R-1}$ désignant les mots de la clé étendue, avec $W_x=K_x$ pour x entier allant de 0 à 4, et R désignant le nombre de répétitions de la clé étendue. Comme illustré sur la vue (a) de la figure 10bis, l'algorithme comprend des opérations de rotation (Rotate), des opérations de permutation successives (SBOX) et des opérations de type ou exclusif (XOR), et une opération de calcul de constante de cycle (Rcon) à partir d'une constante de départ CST de un octet. On a représenté sur la vue (b) de la figure 10bis, sous la forme d'une table de deux colonnes, une liste d'opérations pouvant être mise en oeuvre pour implémenter chaque étape de l'algorithme. La colonne de gauche représente la fonction (FCT) à implémenter et la colonne de droite représente l'implémentation proposée (IMPL) de la fonction. Dans le cas où la fonction FCT est une rotation (Rotate), l'implémentation proposée IMPL est une permutation unique (Shuffle x 1), c'est-à-dire selon une seule configuration de permutation. Dans le cas où la fonction FCT est une suite de permutations (SBOX), l'implémentation proposée IMPL est une succession de 16 permutations (Shuffle x 16). Dans le cas où la fonction FCT est une opération de calcul de constante de cycle, l'implémentation proposée IMPL comprend des opérations de décalage, de comparaison, de soustraction et de ou exclusif (Shift, Compare, Subtraction, XOR). Comme illustré sur la vue (c) de la figure 10bis, on prévoit ici d'entrelacer des opérations (Op) effectuées par le circuit mémoire (128-bit SRAM), représentées en grisé en partie droite de la vue (c) de la figure 10bis, et des opérations effectuées par un processeur (8-bit CPU) externe au circuit mémoire, représentées en grisé et hachuré en partie gauche de la vue (c) de la figure 10bis. Des opérations de ou exclusif (XOR) et de permutation (Shuffle) effectuées sur les clés et portant sur des mots de 32 bits sont mises en oeuvre par le circuit mémoire, de façon que les clés ne soient pas transmises à l'extérieur du circuit mémoire (et notamment sur un bus système entre le processeur et le circuit mémoire). D'autre part, la fonction de calcul de constante de cycle (Rcon) est effectuée par le processeur externe dans la mesure où son entrée est une constante CST indépendante des clés. Les opérations mises en oeuvre par le processeur et les opérations mises en oeuvre par la mémoire sont exécutées en parallèle. Lorsque le processeur termine le calcul de la fonction Rcon, il stocke les résultats dans le circuit mémoire en vue de leur réutilisation pour les calculs mis en oeuvre au sein du circuit mémoire.

Comme l'illustre la vue (c) de la figure 10bis, chaque opération mise en oeuvre par le circuit mémoire (partie droite de la vue (c) de la figure 10bis) a une durée fixe ou sensiblement fixe correspondant à un temps de cycle du circuit mémoire. Ceci facilite grandement le développement d'un logiciel de compilation adapté à générer des programmes exécutables dans un système comprenant un circuit mémoire du type décrit en relation avec les figures 3 à 8bis et un processeur externe au circuit mémoire, adapté à communiquer avec le circuit mémoire.

Les mesures réalisées par le demandeur ont montré qu'en utilisant un circuit mémoire du type décrit ci-dessus, un gain d'un facteur 12,4 en terme de temps d'exécution et un gain d'un facteur 5,6 en terme de consommation électrique peuvent être obtenus par rapport à une implémentation classique, au moyen d'un microprocesseur, par exemple un processeur de type Cortex M0+.

A titre de variante, un circuit mémoire du type décrit en relation avec les figures 3 à 8bis peut être utilisé pour mettre en oeuvre un procédé de compression d'image de type JPEG.

L'algorithme de compression JPEG comprend notamment une étape de transformation des couleurs du domaine RGB (rouge/vert/bleu) vers le domaine YUV (luminance/chrominance). Pour cela, on réalise, pour chaque pixel de l'image, une multiplication d'un vecteur de trois valeurs, correspondant respectivement aux composantes R, G et B du pixel, par une matrice de 3x3 coefficients prédéterminés. Le résultat de cette multiplication est un vecteur de trois valeurs, correspondant respectivement aux composantes Y, U et V de l'image transformée.

La figure 11, partie (A), illustre schématiquement cette opération. La figure 11, partie (B), illustre un exemple de mise en oeuvre de cette opération au moyen d'un circuit mémoire du type décrit en relation avec les figures 3 à 8bis.

Dans l'illustration de la figure 11(A), les trois valeurs R, G, B du pixel définissent un vecteur colonne d'entrée, les valeurs Y, U, V du pixel définissent un vecteur colonne de sortie, et la matrice de transformation est une matrice de trois rangées par trois colonnes, les coefficients de la première rangée de la matrice étant appelés respectivement p0, p1 et p2, les coefficients de la deuxième rangée de la matrice étant appelés respectivement p3, p4 et p5, et les coefficients de la troisième rangée de la matrice étant appelés respectivement p6, p7 et p8.

Dans l'exemple d'implémentation de la figure 11(B), les valeurs des pixels de l'image sont stockées sous la forme d'un vecteur rangée L1 dans une première rangée du circuit mémoire. Sur la figure 11(B), on a représenté un vecteur rangée L1 de neuf valeurs R(1), G(1), B(1), R(2), G(2), B(2), R(3), G(3), B(3), correspondant respectivement aux valeurs R, G et B d'un premier pixel de l'image, aux valeurs R, G et B d'un deuxième pixel de l'image, et aux valeurs R, G et B d'un troisième pixel de l'image.

Les coefficients de la matrice de transformation sont quant à eux stockés sous la forme d'un vecteur rangée L2 dans une deuxième rangée du circuit mémoire. Sur la figure 11(B), on a représenté un vecteur rangée L2 de neuf valeurs p0, p1, p2, p3, p4, p5, p6, p7, p8 correspondant à une concaténation des trois rangées de la matrice de transformation.

On a de plus représenté sur la figure 11(B) un vecteur rangée L3 de neuf valeurs, initialement nulles, stocké dans une troisième rangée du circuit mémoire.

Dans cet exemple, l'opération de transformation des couleurs est entièrement mise en oeuvre au sein du circuit mémoire, en trois cycles comportant chacun une opération de multiplication et addition. A chaque cycle, l'opération L3=L1*L2+L3 est réalisée. Autrement dit, à chaque cycle, chacune des valeurs L3(q) du vecteur L3 est incrémentée de la valeur L1(q)*L2(q), où q est un entier allant de 1 à 9 désignant la position des données dans les vecteurs L1, L2 et L3. Cette opération de multiplication et addition peut être mise en oeuvre par le circuit de calcul 20 du circuit mémoire. Après chaque opération de multiplication et addition et avant l'opération de multiplication et addition suivante, les valeurs du vecteur rangée L2 sont permutées de façon à réaliser un décalage circulaire de trois valeurs (vers la droite dans l'orientation de la figure 11) des coefficients de transformation. Cette opération peut être mise en oeuvre par le circuit de permutation 30 du circuit mémoire.

Ainsi, en trois cycles, la transformation de couleurs de trois pixels de l'image peut être effectuée. En pratique, un nombre de pixels bien plus élevé peut être traité simultanément, en augmentant les dimensions des vecteurs L1, L2 et L3 et en répétant plusieurs fois dans le vecteur L2 la suite des coefficients de transformation p0, p1, p2, p3, p4, p5, p6, p7 et p8. Les trois configurations du circuit de permutation nécessaires à la mise en oeuvre de cette étape peuvent être stockées dans le circuit mémoire, dans la mémoire principale dans l'exemple de la figure 3, ou dans la mémoire additionnelle dans l'exemple de la figure 7. Plus généralement, l'exemple d'implémentation décrit en relation avec la figure 11(B) peut être adapté à toute application comprenant une ou plusieurs opérations de multiplication d'une matrice par un vecteur.

L'algorithme de compression JPEG comprend en outre une étape de sous-échantillonnage de l'image au format YUV. Cette étape peut être mise en oeuvre au moyen du circuit de permutation 30. Plus particulièrement, le circuit de permutation 30 peut être utilisé pour réordonner les données d'une rangée de la mémoire contenant la représentation YUV complète de l'image, de façon à ne conserver qu'une partie de l'image, tel que défini par le standard JPEG. La configuration correspondante du circuit de permutation peut être stockée dans le circuit mémoire, dans la mémoire principale dans l'exemple de la figure 3 ou dans la mémoire additionnelle dans l'exemple de la figure 7.

L'algorithme de compression JPEG comprend de plus une étape de calcul d'une transformée en cosinus discret (DCT) de l'image YUV sous-échantillonnée. Cette étape peut être mise en oeuvre entièrement au sein du circuit mémoire, en utilisant le circuit de calcul 20 et le circuit de permutation 30.

L'algorithme de compression JPEG comprend en outre une étape de codage entropique de blocs de 8*8 valeurs générés à l'issue de l'étape de calcul de DCT. Lors de cette étape, on peut avantageusement tirer profit du circuit de permutation 30 pour réordonner les blocs de 8*8 valeurs issus de l'étape de calcul de DCT.

Ainsi, toutes ou la plupart des étapes d'un algorithme de compression JPEG peuvent être mises en oeuvre directement au sein d'un circuit mémoire du type décrit en relation avec les figures 3 à 8bis, sans avoir à faire transiter des données à l'extérieur du circuit mémoire.

A titre de variante, un circuit mémoire du type décrit en relation avec les figures 3 à 8bis peut être utilisé pour mettre en oeuvre un algorithme d'inférence d'un réseau de neurones artificiels. De nombreuses applications d'intelligence artificielle utilisent des réseaux de neurones artificiels pour prendre des décisions sur la base de données d'entrée. Ces applications sont divisées en deux phases, une phase dite d'apprentissage, et une phase dite d'inférence. Lors de la phase d'apprentissage, l'application apprend à prendre une décision. Par exemple un grand nombre d'images, parmi lesquelles des images représentant un chat et des images ne représentant pas de chat, sont présentées. Les images de chats sont identifiées comme telles et l'application calcule un ensemble de valeurs définissant un réseau de neurones artificiels permettant d'identifier automatiquement une image représentative d'un chat. Lors de la phase d'apprentissage, de larges bases de données sont utilisées, et des capacités calculatoires très importantes sont nécessaires. La phase d'inférence consiste quant à elle à utiliser le réseau de neurones artificiels calculé lors de la phase d'apprentissage pour prendre une décision sur la base de données d'entrée, par exemple pour détecter la présence éventuelle d'un chat sur une image. La phase d'inférence est basée sur des opérations arithmétiques et notamment des multiplications de matrices, pouvant aisément être implémentées dans un circuit mémoire du type décrit en relation avec les figures 3 à 8bis.

On considère ci-après, à titre d'exemple, une opération de multiplication matricielle R=A*B, où A et B sont des matrices de 4 rangées par 4 colonnes définies comme suit :

[Math 1]

$$A = \begin{bmatrix} a00 & a01 & a02 & a03 \\ a10 & a11 & a12 & a13 \\ a20 & a21 & a22 & a23 \\ a30 & a31 & a32 & a33 \end{bmatrix}$$

et

$$[Math\ 2]\qquad B = \begin{bmatrix} b00 & b01 & b02 & b03 \\ b10 & b11 & b12 & b13 \\ b20 & b21 & b22 & b23 \\ b30 & b31 & b32 & b33 \end{bmatrix}$$

Pour mettre en oeuvre l'opération R=A*B au moyen d'un circuit mémoire du type décrit en relation avec les figures 3 à 8bis, chacune des matrices peut être stockée dans une rangée de la mémoire, sous la forme d'un vecteur rangée correspondant à la concaténation des valeurs des quatre rangées de la matrice.

La transposée BT de la matrice B, définie comme suit :

$$[Math\ 3]\qquad BT = \begin{bmatrix} b00 & b10 & b20 & b30 \\ b01 & b11 & b21 & b23 \\ b02 & b12 & b22 & b32 \\ b03 & b13 & b23 & b33 \end{bmatrix}$$

peut alors être calculée en utilisant le circuit de permutation 30 du circuit mémoire.

Les vecteurs rangées contenant la matrice A et la matrice BT peuvent être multipliés point à point en utilisant le circuit de calcul 20 du circuit mémoire.

Les accumulations des résultats des sous-produits (a00*b00, a01*b10, a02*b20, a03*b30, a10*b01, a11*b11, a12*b21, a13*b31, a20*b02, a21*b12, a22*b22, a23*b32, a30*b03, a31*b13, a32*b23, a33*b33) pour calculer les 4*4 coefficients de la matrice R peuvent être réalisées de façon itérative par le circuit de calcul 20 du circuit mémoire.

Ainsi, toutes ou la plupart des étapes d'un algorithme d'inférence d'un réseau de neurones artificiels peuvent être mises en oeuvre directement au sein d'un circuit mémoire du type décrit en relation avec les figures 3 à 8bis, sans avoir à faire transiter des données à l'extérieur du circuit mémoire.

A titre d'exemple, en utilisant un circuit mémoire du type décrit ci-dessus, deux multiplications matricielles peuvent être réalisées en 6 cycles mémoire. Le nombre d'opérations est de 32 par cycle et par matrice (16 additions et 16 multiplications), soit 64 opérations par cycle. En termes de mouvements de données, il convient de fournir une instruction mémoire pour la rotation de la matrice, et quatre instructions mémoire pour l'implémentation des deux multiplications matricielles, soit 5 accès mémoire contre 64 accès en lecture pour une implémentation standard via un microprocesseur.

Plus généralement, l'exemple d'implémentation d'une opération de multiplication de matrices décrit ci-dessus peut être adapté à toute application comprenant une ou plusieurs opérations de multiplications matricielles.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, les modes de réalisations décrits ne se limitent pas aux exemples d'application du circuit mémoire mentionnés dans la présente description. En outre, les modes de réalisation décrits ne se limitent pas aux exemples d'implémentation du circuit de permutation décrits en relation avec les figures 4 à 6. De plus, les modes de réalisation décrits ne se limitent pas à l'exemple particulier de cellules élémentaire de stockage 10 décrit en relation avec la figure 2.

**Revendications**

1. Circuit mémoire (200 ; 300) comportant :

- une pluralité de cellules élémentaires de stockage (10) agencées en matrice selon des rangées et des colonnes, les cellules d'une même colonne partageant une même ligne de bit de lecture (RBL) et une même ligne de bit d'écriture (WBL) ;
- un circuit interne de contrôle (CTRL) adapté à mettre en oeuvre une opération de calcul comprenant l'activation simultanée en lecture d'au moins deux rangées de la matrice ; et
- un circuit de permutation (30) comportant un registre d'entrée de données (32), un registre de configuration (36), et un port de sortie (34), le circuit de permutation (30) étant adapté à fournir sur son port de sortie (34) les données mémorisées dans son registre d'entrée (32) permutées selon une permutation définie en fonction de l'état de son registre de configuration (36),

dans lequel le circuit de permutation (30) est un circuit de routage configurable à architecture parallèle, tel que le temps de mise en oeuvre d'une opération de permutation soit sensiblement fixe quels que soient les contenus respectifs du registre d'entrée et du registre de configuration du circuit de permutation, dans lequel le circuit de contrôle (CTRL) est adapté à mettre en oeuvre une opération de permutation comprenant une étape de lecture de données de configuration stockées à l'intérieur du circuit mémoire et de copie de ces données dans le registre de configuration du circuit de permutation (30).

2. Circuit mémoire (200 ; 300) selon la revendication 1, dans lequel l'opération de permutation comprend :

- l'activation en lecture d'au moins une première rangée de la matrice ;
- la copie de données lues sur les lignes de bit de lecture (RBL) de la matrice dans le registre d'entrée de données (32) du circuit de permutation (30) ;
- la copie de données fournies sur le port de sortie (34) du circuit de permutation (30) sur les lignes de bit d'écriture (WBL) de la matrice ; et
- l'activation en écriture d'au moins une rangée de la matrice.

3. Circuit mémoire (200) selon la revendication 1 ou 2, dans lequel l'opération de permutation comprend :

- l'activation en lecture d'au moins une deuxième rangée de la matrice ; et
- la copie de données lues sur les lignes de bit de lecture (RBL) de la matrice dans le registre de configuration (36) du circuit de permutation (30).

4. Circuit mémoire (300) selon la revendication 1 ou 2, comprenant, en plus de la matrice de cellules élémentaires de stockage (10), une mémoire additionnelle (50) destinée à stocker des données de configuration du circuit de permutation (30).

5. Circuit mémoire (300) selon la revendication 4, dans lequel l'opération de permutation comprend en outre la copie de données lues dans la mémoire additionnelle (50) dans le registre de configuration (36) du circuit de permutation (30).

6. Circuit mémoire (300) selon la revendication 4 ou 5, dans lequel la mémoire additionnelle (50) est une mémoire non volatile.

7. Circuit mémoire (200 ; 300) selon l'une quelconque des revendications 1 à 6, dans lequel le circuit de permutation (30) comprend une pluralité de cellules élémentaires de permutation (40) comprenant chacune deux entrées de données e1 et e2, deux sorties de données s1 et s2, et une entrée de configuration c.

8. Circuit mémoire (200 ; 300) selon la revendication 7, dans lequel le circuit de permutation comprend $(K/2)^*(2^*\log_2(K)-1)$ cellules élémentaires de permutation (40) agencées selon un réseau de Benes, où K est un entier désignant la dimension du registre d'entrée (32) et du port de sortie (34) du circuit de permutation (30).

9. Circuit mémoire (200 ; 300) selon la revendication 7, dans lequel le circuit de permutation comprend 16 cellules élémentaires de permutation (40) agencées selon 5 rangées, les rangées de rang l=1 à l=3 comportant chacune 4 cellules élémentaires (40), et les rangées de rang l=4 à l=5 comportant chacune 2 cellules élémentaires (40), le registre d'entrée (32) et le port de sortie (34) du circuit de permutation (30) étant de dimension 8, et l étant un entier allant de 1 à 5.

10. Circuit mémoire (200 ; 300) selon l'une quelconque des revendications 1 à 9, comportant en outre un circuit d'entrée-sortie (IO) configurable pour relier les lignes de bit de lecture (RBL) de la matrice au registre d'entrée (32) du circuit de permutation (30) et/ou pour relier les lignes de bit d'écriture (WBL) de la matrice au port de sortie (34) du circuit de permutation (30).

11. Circuit mémoire (200 ; 300) selon la revendication 10, comportant en outre un circuit de calcul (20) adapté à mettre en oeuvre des opérations logiques ou arithmétiques ayant pour opérandes des données mémorisées dans la matrice de cellules élémentaires de stockage (10) du circuit mémoire.

**12.** Circuit mémoire (200 ; 300) selon la revendication 11, dans lequel le circuit d'entrée-sortie (IO) est en outre configurable pour relier les lignes de bit de lecture (RBL) de la matrice à un registre d'entrée (22) du circuit de calcul (20) et/ou pour relier les lignes de bit d'écriture (WBL) de la matrice à un port de sortie (24) du circuit de calcul (20).

**Patentansprüche**

**1.** Eine Speicherschaltung (200; 300), die Folgendes aufweist:

- eine Vielzahl von Elementarspeicherzellen (10), die in einem Array von Zeilen und Spalten angeordnet sind, wobei die Zellen einer gleichen Spalte eine gleiche Lese-Bitleitung (RBL = read bit line) und eine gleiche Schreib-Bitleitung (WBL = write bit line) teilen
- eine interne Steuerschaltung (CTRL), die in der Lage ist, eine Rechenoperation zu implementieren, die die gleichzeitige Aktivierung im Lesemodus von mindestens zwei Zeilen des Arrays umfasst; und
- eine Shuffle-Schaltung bzw. Misch-Schaltung (30), die ein Dateneingangsregister (32), ein Konfigurationsregister (36) und einen Ausgangsanschluss (34) aufweist, wobei die Shuffle-Schaltung (30) in der Lage ist, an ihrem Ausgangsanschluss (34) die in ihrem Eingangsregister (32) gespeicherten Daten zu liefern, die gemäß einer Misch- bzw. Shuffle-Operation gemischt wurden, die gemäß dem Zustand ihres Konfigurationsregisters (36) definiert ist,

wobei die Shuffle-Schaltung (30) eine konfigurierbare Routing-Schaltung mit einer parallelen Architektur ist, so dass die Zeit der Implementierung einer Shuffle-Operation im Wesentlichen konstant ist, unabhängig von den jeweiligen Inhalten des Eingangsregisters und des Konfigurationsregisters der Shuffle-Schaltung, wobei die Steuerschaltung (CTRL) in der Lage ist, eine Shuffle-Operation zu implementieren, die einen Schritt des Lesens von in der Speicherschaltung gespeicherten Konfigurationsdaten und des Kopierens der Daten in das Konfigurationsregister der Shuffle-Schaltung (30) aufweist.

**2.** Speicherschaltung (200; 300) nach Anspruch 1, wobei die Shuffle-Operation Folgendes aufweist:

- Aktivieren im Lesemodus von mindestens einer ersten Zeile des Arrays;
- Kopieren von aus den Lese-Bitleitungen (RBL) des Arrays gelesenen Daten in das Dateneingangsregister (32) der Shuffle-Schaltung (30);
- Kopieren von Daten, die an den Ausgangsanschluss (34) der Shuffle-Schaltung (30) geliefert werden, auf die Schreib-Bitleitungen (WBL) des Arrays; und
- Aktivieren von mindestens einer Zeile des Arrays im Schreibmodus.

**3.** Speicherschaltung (200) nach Anspruch 1 oder 2, wobei die Shuffle-Operation Folgendes aufweist:

- Aktivieren mindestens einer zweiten Zeile des Arrays im Lesemodus; und
- Kopieren von aus den Lese-Bitleitungen (RBL) des Arrays gelesenen Daten in das Konfigurationsregister (36) der Shuffle-Schaltung (30).

**4.** Speicherschaltung (300) nach Anspruch 1 oder 2, die zusätzlich zu dem Array von Elementarspeicherzellen (10) einen zusätzlichen Speicher (50) aufweist, der dazu bestimmt ist, Daten zur Konfiguration der Shuffle-Schaltung (30) zu speichern.

**5.** Speicherschaltung (300) nach Anspruch 4, wobei die Shuffle-Operation ferner das Kopieren der aus dem zusätzlichen Speicher (50) gelesenen Daten in das Konfigurationsregister (36) der Shuffle-Schaltung (30) aufweist.

**6.** Speicherschaltung (300) nach Anspruch 4 oder 5, wobei der zusätzliche Speicher (50) ein nichtflüchtiger Speicher ist.

**7.** Speicherschaltung (200; 300) nach einem der Ansprüche 1 bis 6, wobei die Shuffle-Schaltung (30) mehrere elementare Shuffle-Zellen (40) aufweist, die jeweils zwei Dateneingänge e1 und e2, zwei Datenausgänge s1 und s2 und einen Konfigurationseingang c aufweisen.

**8.** Speicherschaltung (200; 300) nach Anspruch 7, wobei die Shuffle-Schaltung $(K/2)*(2*\log_2(K)-1)$ elementare Shuffle-Zellen (40) aufweist, die in einem Benes-Netzwerk angeordnet sind, wobei K eine ganze Zahl ist, die die Dimension des Eingangsregisters (32) und des Ausgangsports (34) der Shuffle-Schaltung (30) bezeichnet.

**9.** Speicherschaltung (200; 300) nach Anspruch 7, wobei die Shuffle-Schaltung 16 elementare Shuffle-Zellen (40) umfasst, die in 5 Zeilen angeordnet sind, wobei die Zeilen des Rangs I = 1 bis I = 3 jeweils 4 elementare Zellen (40) aufweisen und die Zeilen des Rangs I = 4 bis I = 5 jeweils 2 elementare Zellen (40) umfassen, wobei das Eingangsregister (32) und der Ausgangsanschluss (34) der Shuffle-Schaltung (30) die Dimension 8 haben und I eine ganze Zahl im Bereich von 1 bis 5 ist.

**10.** Speicherschaltung (200; 300) nach einem der Ansprüche 1 bis 9, ferner mit einer Eingangs-Ausgangs-Schaltung (IO), die so konfiguriert werden kann, dass sie die Lese-Bitleitungen (RBL) des Arrays mit dem Eingangsregister (32) der Shuffle-Schaltung (30) koppelt und/oder die Schreib-Bitleitungen (WBL) des Arrays mit dem Ausgangsanschluss (34) der Shuffle-Schaltung (30) koppelt.

**11.** Speicherschaltung (200; 300) nach Anspruch 10, ferner mit einer Berechnungsschaltung (20), die in der Lage ist, logische oder arithmetische Operationen zu implementieren, die in dem Array von Elementarspeicherzellen (10) der Speicherschaltung gespeicherte Daten als Operanden haben.

**12.** Speicherschaltung (200; 300) nach Anspruch 11, wobei die Eingabe-Ausgabe-Schaltung (IO) ferner konfigurierbar ist, um die Lese-Bitleitungen (RBL) des Arrays mit einem Eingaberegister (22) der Berechnungsschaltung (20) zu koppeln und/oder um die Schreib-Bitleitungen (WBL) des Arrays mit einem Ausgangsanschluss (24) der Berechnungsschaltung (20) zu koppeln.

**Claims**

**1.** A memory circuit (200; 300) comprising:

- a plurality of elementary storage cells (10) arranged in an array of rows and of columns, the cells of a same column sharing a same read bit line (RBL) and a same write bit line (WBL);
- an internal control circuit (CTRL) capable of implementing a calculation operation comprising the simultaneous activation in read mode of at least two rows of the array; and
- a shuffle circuit (30) comprising a data input register (32), a configuration register (36), and an output port (34), the shuffle circuit (30) being capable of delivering on its output port (34) the data stored in its input register (32) shuffled according to a shuffle operation defined according to the state of its configuration register (36), wherein the shuffle circuit (30) is a configurable routing circuit with a parallel architecture, such that the time of implementation of a shuffle operation is substantially constant whatever the respective contents of the input register and of the configuration register of the shuffle circuit,
wherein the control circuit (CTRL) is capable of implementing a shuffle operation comprising a step of reading configuration data stored inside of the memory circuit and of copying the data into the configuration register of the shuffle circuit (30).

**2.** The memory circuit (200; 300) of claim 1, wherein the shuffle operation comprises:

- activating in read mode at least a first row of the array;
- copying data read from the read bit lines (RBL) of the array into the data input register (32) of the shuffle circuit (30);
- copying data supplied on the output port (34) of the shuffle circuit (30) onto the write bit lines (WBL) of the array; and
- activating in write mode at least one row of the array.

**3.** The memory circuit (200) of claim 1 or 2, wherein the shuffle operation comprises:

- activating in read mode at least a second row of the array; and
- copying data read from the read bit lines (RBL) of the array into the configuration register (36) of the shuffle circuit (30).

**4.** The memory circuit (300) of claim 1 or 2, comprising, in addition to the array of elementary storage cells (10), an additional memory (50) intended to store data of configuration of the shuffle circuit (30).

**5.** The memory circuit (300) of claim 4, wherein the shuffle operation further comprises copying the data read from the additional memory (50) into the configuration register (36) of the shuffle circuit (30).

6. The memory circuit (300) of claim 4 or 5, wherein the additional memory (50) is a non-volatile memory.

7. The memory circuit (200; 300) of any of claims 1 to 6, wherein the shuffle circuit (30) comprises a plurality of elementary shuffle cells (40), each comprising two data inputs e1 and e2, two data outputs s1 and s2, and one configuration input c.

8. The memory circuit (200; 300) of claim 7, wherein the shuffle circuit comprises $(K/2)*(2*\log_2(K)-1)$ elementary shuffle cells (40) arranged in a Benes network, where K is an integer designating the dimension of the input register (32) and of the output port (34) of the shuffle circuit (30).

9. The memory circuit (200; 300) of claim 7, wherein the shuffle circuit comprises 16 elementary shuffle cells (40) arranged in 5 rows, the rows of rank 1 = 1 to 1 = 3 each comprising 4 elementary cells (40) and the rows of rank 1 = 4 to 1 = 5 each comprising 2 elementary cells (40), the input register (32) and the output port (34) of the shuffle circuit (30) being of dimension 8, and 1 being an integer in the range from 1 to 5.

10. The memory circuit (200; 300) of any of claims 1 to 9, further comprising an input-output circuit (IO) configurable to couple the read bit lines (RBL) of the array to the input register (32) of the shuffle circuit (30) and/or to couple the write bit lines (WBL) of the array to the output port (34) of the shuffle circuit (30) .

11. The memory circuit (200; 300) of claim 10, further comprising a calculation circuit (20) capable of implementing logic or arithmetic operations having data stored in the array of elementary storage cells (10) of the memory circuit as operands.

12. The memory circuit (200; 300) of claim 11, wherein the input-output circuit (IO) is further configurable to couple the read bit lines (RBL) of the array to an input register (22) of the calculation circuit (20) and/or to couple the write bit lines (WBL) of the array to an output port (24) of the calculation circuit (20).

Fig 1

Fig 2

Fig 3

Fig 4

Fig 5

Fig 6

Fig 7

Fig 8

83

CONFIG
DATA

②

④

50 (a)

(b)

SRAM ARRAY

*NVM MEMORY*

*SRAM ARRAY*

①

... NVM MEMORY

MOD

CHE

20/30

IO

40

COMPUT
DATA

③

... NVM MEMORY

MOD

81

40

30

①Read Config

②Read Data

(c) ③Shuffle Data

④Write Data

Shuffle Block

Fig 8bis

Fig 9

Fig 10

(a)  (b)

$K_0, K_1, K_2, K_3$ : 32 bit

$W_0, W_1, ... W_{4R-1}$: 32bit

$(W_{0 \to 4} = K_{0 \to 4})$

| FCT | IMPL |
|------|------|
| Rotate | Shuffle x 1 |
| SBOX | Shuffle x 16 |
| Reon | Shift, Compare, Subtraction, Xor |

(c)

Fig 10 bis

Fig 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3252774 A
- FR 1762534
- FR 1762470
- FR 1763221
- FR 1762468